# EUROPEAN PATENT SPECIFICATION

(11) **EP 1 032 026 B1**
(45) Date of publication and mention of the grant of the patent: **17.09.2008**
(21) Application number: 00301234.1
(22) Date of filing: 17.02.2000
(51) Int. Cl.: H01L 21/311, H01L 21/321, G03F 7/42, H01L 21/3213, H01L 21/306

(54) **Method of photoresist ash residue removal**
Verfahren zur Entfernung von Rückständen nach Photoresistveraschung
Procédé d'élimination de residus de brûlage de réserve photographique

(30) Priority: 19.02.1999 US 120866 P
(43) Date of publication of application: 30.08.2000
(73) Proprietor: Axcelis Technologies, Inc., Beverly, MA 01915-1053 (US)
(72) Inventor: Berry, Ivan Louis, III, Ellicott City, Maryland 21042 (US); Rounds, Stuart Nathan, Frederick, Maryland 21703 (US); Owens, Michael Shawn, Baltimore, Maryland 21210 (US); Hallock, John Scott, Potomac, Maryland 20854 (US); Dahimene, Mahmoud, Gaithersburg, Maryland 20879 (US)
(74) Representative: Jacob, Reuben Ellis

(56) References cited:
- EP-A- 0 875 926
- US-A- 5 669 979
- US-A- 5 814 156
- PATENT ABSTRACTS OF JAPAN vol. 015, no. 371 (E-1113), 18 September 1991 (1991-09-18) -& JP 03 147322 A (FUJITSU LTD), 24 June 1991 (1991-06-24)
- PATENT ABSTRACTS OF JAPAN vol. 016, no. 158 (E-1191), 17 April 1992 (1992-04-17) -& JP 04 010622 A (TOKYO ELECTRON LTD;OTHERS: 01), 14 January 1992 (1992-01-14)

## Description

This invention relates to semiconductor device manufacture, and is directed to an improved method of stripping photoresist, removing residues, or cleaning wafer surface.

In the manufacture of integrated circuits, the technique of photolithography is required to form the integrated circuit patterns. In the practice of this technique, a semiconductor wafer is coated with a photoresist. The photoresist is then exposed to ultraviolet radiation which is passed through a mask so that a desired pattern is imaged on the photoresist. This causes changes in the solubility of the exposed areas of the photoresist such that after development in a suitable developer a desired pattern is fixed on the wafer, whereupon the photoresist may hardbaked or photostabilized to enable it to withstand subsequent processing.

After the integrated circuit components are formed, it is generally necessary to remove (strip) the photoresist from the wafer as it has already served its useful purpose. The relative ease or difficulty with which the photoresist may be stripped depends on the degree to which physical and chemical changes have been induced in the photoresist during plasma etching or ion implantation processes and on the degree to which crosslinking has occurred in the photoresist. Thus, it is generally known that a significant degree of hard baking and, to an even greater extent, the processes of plasma etching and ion implantation induce physical and chemical changes in the photoresist, so that stripping is particularly difficult.

It has been found that plasma ashing of the photoresist from a wafer after it has served its purpose frequently results in tenacious fluoride containing residues that cannot be generally removed by oxygen plasmas. These residues are difficult to remove in part because they contain substantial amounts of fluorine containing substance(s) generated during an earlier fluorine based plasma etching step. The residue may be rendered even more resistant to removal by incorporation of sputtered metal or other inorganic materials.

To address this problem, some have employed wet cleaning techniques utilizing e.g., amine-based solvents (see, for example, Wang, Y; Graham, S.W.; Chan, L.; Loong, S.J. Eletrochem. Soc., Vol. 144, No. 4, April 1977). This approach, however, is inherently undesirable as it involves the use of large quantities of hazardous chemicals and necessitates their costly disposal. For a wet cleaning process ultimately a water only rinse would be most acceptable from health and economic perspectives, as probably no disposal costs would be incurred. The hydrophobic nature of the tenacious resist residues, however, renders them unaffected by pure water.

US 5,669,979 and US 5,814,156 describe a method for cleaning a substrate surface. Foreign material on a surface of a substrate is processed to form a reaction product, by the combination of providing a directed flow of a fluid, including a reactant, in the vicinity of the foreign material, and delivering a beam of UV radiation using a laser to aid the reactant to react with the foreign material to form the reaction product. These methods lead to the vaporisation of the foreign material from a solid to a gas form, which make it easier to remover the foreign material from the substrate surface.

JP 03-1473222 describe a method for cleaning a substrate surface, comprising a first step exposing fluorine atoms on the surface, and a second step consisting in the exposition of the substrate to a gas containing ammonia, which reacts with the exposed fluorine atoms. The products thereby obtained are separated into a gaseous phase. The method is carried out at room temperature and the substrate is irradiated with UV rays.

It is thus an object of the invention to provide an improved method of removing fluorine-containing residues.

In accordance with the present invention, the above object is accomplished by providing an improved method for removing photoresist ash residues in which the residue-contaminated wafers are exposed to a combination of heat, ultraviolet radiation, and a reactive gas This combined treatment renders the residue more hydrophilic, and easier to remove by rinsing with deionized water.

The invention will be better understood by referring to the accompanying drawings wherein:
Fig. 1 is a photomicrograph of a wine glass via showing the residue remaining after the performance of an ashing process.
Fig. 2 is a photomicrograph of the same wine glass via as in Fig. 1 after the process of the present invention has been employed.

As discussed above, stripping of photoresists (and their by-products) may present particular difficulty because of the processing which the wafer has undergone. Photoresist hard baking and photostabilization, as well as plasma etching and ion implantation are illustrative of those processes which induce physical and chemical changes in photoresist, and make it more difficult to strip.

As device dimensions have become smaller, plasma etch recipes have been formulated to increasingly take advantage of sidewall passivation to obtain the desired selectivity and Critical Dimension (CD) control. Typically, this is achieved by using an etch chemistry that allows selective polymer deposition on surfaces where a slower etch rate is desired. For example, to achieve anisotropic etching of SiO₂, C, F, H containing gas mixtures may be used. Typically, fluorine is the principal etching component in the plasma. Disassociated CFₓ(x=1, 2 and 3) molecules are responsible for the formation of fluorine containing deposits on the bottom and vertical sidewalls of the contact or via holes. The competition between deposition and etch is used to control the etch profile. In some cases, toward the end of the process, during the over-etch phase, a nonvolatile metal such as Al from the exposed underlayer may be sputtered from the bottom of the hold and redeposited on the passivated sidewalls. Typically, the result is a metal-inbedded fluorine containing residue which remains in the via hole. Similar schemes are used for metal and polysilicon etch.

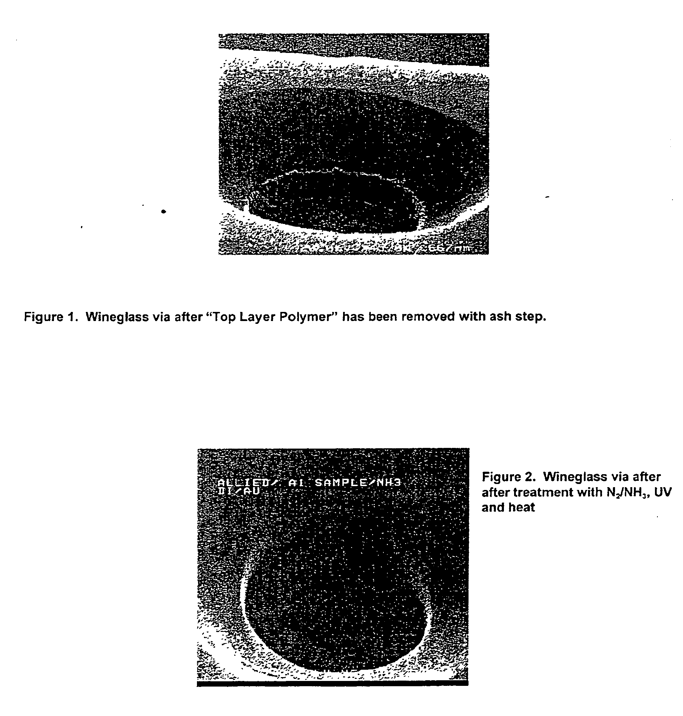

Such residues generally cannot be removed by oxygen plasma. However, directional ion bombardment with fluorine-containing plasma is typically effective in removing them from the bottom of contact or via holes, but not from the sidewalls due to the small angle of incidence. Fig. 1 is a photomicrograph of a "wineglass" via after the top layer polymer has been removed by performing an ashing process by a downstream plasma asher using a fluorine containing gas. It is noted that there is residue remaining on the bottom of the via and on the lower portion of the sidewalls.

In accordance with the present invention, this residue is removed by exposure to a combination of heat, ultraviolet radiation, and a reactive gas. Such reactive gases include ammonia, sulfur dioxide, and hydrogen. Preferred treatments include ammonia, hydrazine, and sulfur dioxide. These chemicals may be used in diluted form (i.e., in a inert carrier gas) and/or in mixtures, and at various pressures. Frequently, their use in diluted form is sufficient to effect the desired treatment while substantially reducing the hazards associated with accidental exposure to the vapors. At times it may be advantageous to accomplish the treatment under reduced pressures to minimize ultraviolet absorption by the atmosphere between the ultraviolet source and the residues.

In performing a process according to the present invention, the gas may be applied to a substrate while the substance is being irradiated with ultraviolet radiation and is at an elevated temperature. The ultraviolet radiation may be applied so as to blanket the residue; therefore a laser typically is not an appropriate light source. However, various sources, such as high intensity mercury arc lamps, microwave excited plasma lamps, excimer lamps, and other high intensity ultraviolet light sources, which are capable of providing a blanketing irradiation, may be used.

The substance may be heated to an elevated temperature by various means. According to one embodiment, a wafer is situated on a temperature-controlling chuck and irradiated with a source emitting ultraviolet and infrared radiation while applying the reactive gas(es). The infrared radiation will heat the wafer, and the amount of temperature rise will be controlled by the mass of the temperature controlling chuck. Such a system is disclosed is connection with a photostabilizion chamber in U.S. Patent No. 4,548,688.

The exact nature of the chemical transformations that occur during treatment can depend on the nature of the gas or vapor used, the nature of the resist residue, and the intensity and the duration of exposure to both ultraviolet radiation and heat. In many cases, the polymer residues are quite thermally stable and transparent to all but the lowest wavelength ultraviolet radiation. By using chemical vapors which are themselves thermally or photochemically reactive, however, highly reactive intermediates may be formed which are then capable of interacting with the residue and rendering it more hydrophilic. In the case of hydrazine, which does not form part of the invention, it is speculated that N₂H₃,·NH₂,·H (atomic hydrogen), and :NH (nitrene) formed by ultraviolet photolysis react with the polymer surface to ultimately incorporate amino groups as well as effecting fluorine replacement by hydrogen. Similarly, ammonia is known to generate -NH₂ and -H under ultraviolet irradiation, which can then react in the same way as the hydrazine photolysis products.

This invention may be used with various types of photoresists including but not limited to I-line resists, such as those based on novolac and diazonaphthoguinone resins, deep UV resists, such as those based on partially protected poly(hydroxystyrene) resins or hydroxystyrene./methacrylate.copolymers, and 193nm resists, such as those based on methacrylate or cycloolefin resins.

In a specific process, the wafer is processed in a downstream plasma chamber to ash photoresist and partially remove the fluorine containing residues from the via holes. The gases used are O₂/N₂/H₂/CF₄ at a pressure of 199.98 Pa (1.5 Torr) with 2000 W of microwave power. After this step, metal-containing residue is left on the bottom of the hole and in the lower region of the sidewalls, as shown in Fig. 1. It is believed that a relatively high concentration of metal which is sputtered from bottom of the hole during over-etch is present.

To remove the remaining residues, the wafer is exposed to ultraviolet radiation in a gas mixture of 5% NH₃ and 95% N₂ at 101.325 Pa (760 Torr) and 120°C, at a flow rate of 2000 sccm for 60 seconds. The wafer is then rinsed with deionized water to remove residues rendered watersoluble by the NH₃-UV. A photostabilizer chamber (Eaton PCU) as previously described may be used to effect the exposure. As is shown in Fig. 2, the wafer is free of residues after the rinse step.

## Claims

1. A method of processing a semiconductor wafer comprising the steps of: coating the wafer with a photoresist;
imaging a pattern on the photoresist with ultraviolet radiation;
developing the photoresist;
hardbaking or stabilizing the photoresist;
forming integrated circuit components on the wafer; and
removing the photoresist from the wafer, by
a) performing an ashing process on the photoresist which removes the photoresist except for a residue; and
b) removing the residue by applying a gas selected from ammonia, hydrogen and sulfur dioxide to which the residue is reactive, by
i) applying said gas to which the residue is reactive to the wafer while the temperature of the wafer is at an elevated level with respect to ambient temperature;
ii) exposing the wafer to ultraviolet radiation using a high intensity ultraviolet light source capable of providing a blanketing radiation with said gas applying step, wherein the applying and exposing steps are continued for a period of time sufficient to render the residue hydrophilic enough to be removable with deionized water; and
iii) rinsing the substrate with deionized water.

2. The method of claim 1 wherein the light source comprises a ligh intensity mercury are lamp, a microwave excited plasma lamp or on excimer lamp.

## Patentansprüche

1. Verfahren zur Verarbeitung eines Halbleiterwafers, umfassend die folgenden Schritte:
Beschichten des Wafers mit einem Photoresist;
Abbilden eines Musters auf dem Photoresist mit ultravioletter Strahlung;
Entwickeln des Photoresists;
Nachhärten oder Stabilisieren des Photoresists;
Bilden integrierter Schaltungsbestandteile auf dem Wafer; und
Entfernen des Photoresists vom Wafer durch
a) Durchführen eines Veraschungsprozesses auf dem Photoresist, der das Photoresist bis auf einen Rückstand entfernt; und
b) Entfernen des Rückstands durch Aufbringen eines aus Ammoniak, Wasserstoff und Schwefeldioxid gewählten Gases, in Bezug auf das der Rückstand reaktionsfähig ist, indem
i) das Gas, in Bezug auf das der Rückstand reaktionsfähig ist, auf den Wafer aufgebracht wird, während sich die Temperatur des Wafers in Bezug auf die Umgebungstemperatur bei einem erhöhten Grad befindet;
ii) der Wafer mit dem Schritt der Gasaufbringung unter Verwendung einer Ultraviolettlichtquelle mit hoher Stärke, die fähig ist, eine überdeckende Strahlung bereitzustellen, einer ultravioletten Strahlung ausgesetzt wird, wobei der Aufbringungs- und der Aussetzungsschritt für einen Zeitraum fortgesetzt werden, der ausreicht, um den Rückstand ausreichend hydrophil zu machen, damit er mit entionisiertem Wasser entfernbar ist; und
iii) das Substrat mit entionisiertem Wasser gespült wird.

2. Verfahren nach Anspruch 1, wobei die Lichtquelle eine Quecksilberbogenlampe mit hoher Stärke, eine mikrowellenangeregte Plasmalampe oder eine Exzimerlampe umfasst.

## Revendications

1. Procédé de traitement d'une tranche de semiconducteur comprenant les étapes consistant à :
◆ enduire la tranche d'une résine photosensible ;
◆ transférer l'image d'un modèle sur la résine photosensible à l'aide d'un rayonnement ultraviolet ;
◆ développer la résine photosensible ;
◆ cuire ou stabiliser le vernis photosensible ;
◆ former des composants de circuits intégrés sur la tranche ; et
◆ éliminer la résine photosensible de la tranche, en
a) exécutant un procédé de brûlage sur la résine photosensible qui élimine la résine photosensible à l'exception de résidus ; et
b) éliminant les résidus en appliquant un gaz sélectionné parmi l'ammoniaque, l'hydrogène et le dioxyde de soufre vis-à-vis duquel les résidus sont réactifs, par les étapes
i) d'application dudit gaz vis-à-vis duquel les résidus sont réactifs à la tranche tandis que la température de la tranche est portée à un niveau élevé par rapport à la température ambiante ;
ii) d'exposition de la tranche à un rayonnement ultraviolet en utilisant une source de lumière ultraviolette de forte intensité capable de fournir un rayonnement d'isolement avec ladite étape d'application de gaz, les étapes d'application et d'exposition étant poursuivies pendant une période de temps suffisante pour rendre les résidus assez hydrophiles pour pouvoir les éliminer avec de l'eau déionisée ; et
iii) de rinçage du substrat avec de l'eau déionisée.

2. Procédé selon la revendication 1, dans lequel la source de lumière comprend une lampe à vapeur de mercure de forte intensité, une lampe à plasma excitée micro-ondes ou une lampe à excimère.
